# FASCICULE DE BREVET EUROPEEN

(11) **EP 1 818 942 B1**
(45) Date de publication et mention de la délivrance du brevet: **06.07.2011**
(21) Numéro de dépôt: 07290181.2
(22) Date de dépôt: 13.02.2007
(51) Int. Cl.: G11C 11/412, H03K 3/356

(54) **Dispositif de mémoire non volatile**
Nichtflüchtige Speichervorrichtung
Non-volatile memory device

(30) Priorité: 14.02.2006 FR 0601292
(43) Date de publication de la demande: 15.08.2007
(73) Titulaire: STMICROELECTRONICS SA, 92120 Montrouge (FR)
(72) Inventeur: Dedieu, Laurent, 38190 Le Champ-Pres-Forges (FR); Lefebvre, Sébastien, 38330 Montbonnot (FR)
(74) Mandataire: Gendron, Vincent Christian

(56) Documents cités:
- US-A- 4 146 802
- US-A- 5 825 224
- US-A- 6 028 453

## Description

La présente invention concerne de façon générale le domaine des mémoires non volatiles et, en particulier, la structure de cellules de mémoire de ce type.

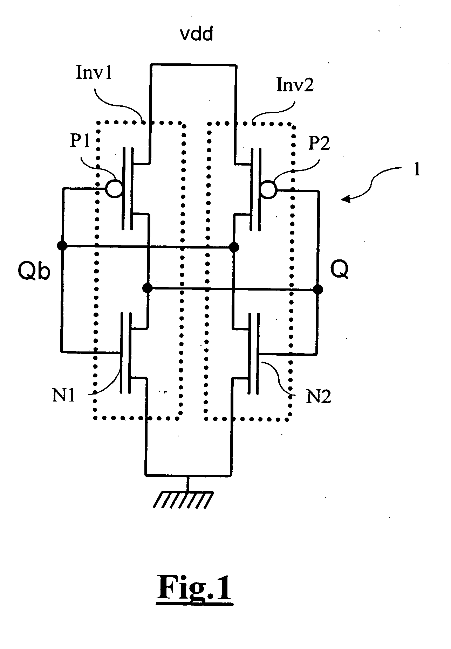

La figure 1 illustre un exemple de structure de cellule mémoire de l'état de la technique. Cette cellule mémoire comprend un circuit bistable 1 à base de transistors en technologie CMOS. Ce bistable est typiquement constitué de deux inverseurs Inv1 et Inv2 connectés tête bêche (montage dit « cross coupled » selon la terminologie anglo-saxonne), chaque inverseur formant alors un noeud de stockage, et présente des bornes de lecture/écriture complémentaires Q et Qb. Chaque noeud de stockage Inv1 et Inv2 est constitué d'un transistor nMos, respectivement N1 et N2, et d'un transistor pMos, respectivement P1 et P2.

Les transistors pMos de chacun des noeuds de stockage sont programmables, de sorte à pouvoir décaler la tension de seuil d'un pMos par rapport à l'autre et, en conséquence, décaler la tension de seuil d'un inverseur par rapport à l'autre. Les deux inverseurs possédant ainsi des tensions de seuil différentes, lors de la mise en charge de la cellule, l'un des deux inverseurs est prévu pour basculer plus vite que l'autre, permettant, suivant l'état de programmation, de capturer l'information logique 1 ou 0 souhaitée au niveau de la borne Q, tandis que l'état logique complémentaire est alors atteint sur la borne Qb.

Par exemple, prenons le cas où le transistor pMos P1 de l'inverseur Inv1 est programmé de telle façon que sa tension de seuil Vth1 est supérieure à la tension de seuil Vth2 du transistor pMos P2 de l'inverseur Inv2 (on parle ici en valeur absolue, cette remarque restant valable pour l'ensemble de la description qui va suivre). Dans cette configuration, à la mise sous tension, une phase d'initialisation est conduite au cours de laquelle les deux transistors pMos P1 et P2 sont rendus passants tandis que les deux nMos N1 et N2 sont bloqués. Cependant, étant donné que la tension de seuil Vth1 est choisie supérieure à la tension de seuil Vth2, le transistor P2 est plus rapide et va basculer avant l'autre pMos de sorte que la borne Q passe à 0 lorsque l'alimentation Vdd est stabilisée, tandis que dans le même temps, l'état logique complémentaire 1 est atteint sur la borne Qb.

De la même façon, si l'on choisit Vth1<Vth2, après la phase de pré-charge lors de la montée de l'alimentation Vdd, les états logiques 1 et 0 sont respectivement atteints sur les bornes Q et Qb.

Dans cette configuration, la cellule mémoire s'initialise forcément lors de la phase de montée de l'alimentation. Un tel fonctionnement implique la prise en compte de certaines contraintes au niveau de cette phase de montée de l'alimentation, notamment en ce qui concerne le temps d'établissement de la tension d'alimentation. En effet, si la montée de la tension d'alimentation est trop rapide, le comportement de la cellule risque d'être fortement perturbé, conduisant même à une initialisation de la cellule inverse à celle normalement attendue. Un mode de fonctionnement sûr d'une telle cellule mémoire implique donc une montée de la tension d'alimentation assez lente, de l'ordre de quelques millisecondes.

Par ailleurs, une autre contrainte à prendre en compte concerne la taille des transistors impliqués dans ces cellules. Plus précisément, il est nécessaire de prévoir des transistors assez gros en taille pour s'affranchir des effets indésirables liés aux défauts d'appariement, appelés « mismatch » dans la littérature anglo-saxonne. En effet, des problèmes de répétabilité dans le procédé de fabrication des transistors peuvent faire que des transistors MOS, prévus pour être strictement identiques, présentent néanmoins des caractéristiques qui divergent, par exemple au niveau de leur longueur de grille. En choisissant des transistors de large dimension, la variation de longueur de grille rapportée à la longueur totale devient alors trop minime pour pouvoir influencer le fonctionnement.

Or, un tel choix, bien qu'améliorant la robustesse de l'ensemble, se fait au détriment d'autres nécessités et notamment de la sécurité, puisque ces cellules mémoires, de par leur taille, sont alors facilement identifiables au sein d'un circuit. Elles peuvent donc être inadaptées à certaines applications de sécurité.

US 6028453 décrit un dispositif de mémorisation d'un but mémoire comprenant un circuit bistable présentant des première et deuxième bornes de lecture/écriture complémentaires.

La présente invention vise donc à résoudre un ou plusieurs de ces inconvénients. L'invention porte ainsi sur un dispositif de mémorisation d'un bit mémoire comprenant un circuit bistable présentant des première et deuxième bornes de lecture/écriture complémentaires, caractérisé en ce qu'il comprend une entrée d'initialisation connectée audit circuit bistable, ladite entrée étant prévue pour prendre un premier état commandant une phase de pré-charge dudit circuit bistable et, suite à ladite phase de pré-charge, pour prendre un second état commandant l'établissement dudit bit mémoire et de son complément au niveau des dites bornes de lecture/écriture.

le circuit bistable utilisé pour le dispositif de mémorisation selon l'invention comprend :
- des premier et deuxième transistors connectés entre la masse et respectivement les première et deuxième bornes, et dont les grilles sont connectées respectivement aux deuxième et première bornes;
- des troisième et quatrième transistors connectés respectivement entre les première et deuxième bornes et une source d'alimentation, et dont les grilles sont connectées respectivement aux deuxième et première bornes.

De préférence, les premier et deuxième transistors sont de type nMos, et les troisième et quatrième transistors sont de type pMos.

Selon un premier mode de réalisation, le dispositif selon l'invention comprend :
- des cinquième et sixième transistors, connectés entre la masse et respectivement les deuxième et première bornes et dont les grilles sont connectées à l'entrée d'initialisation dudit dispositif ;
- des septième et huitième transistors, connectés respectivement entre les première et deuxième bornes et respectivement les troisième et quatrième transistors et dont les grilles sont connectées à ladite entrée d'initialisation dudit dispositif.

Selon une variante de ce premier mode de réalisation, les septième et huitième transistors sont connectés, de façon alternative, respectivement entre les troisième et quatrième transistors et la source d'alimentation, leur grille étant connectée à l'entrée d'initialisation dudit dispositif.

Avantageusement, selon ce premier mode de réalisation, les couples de troisième et septième transistors et de quatrième et huitième transistors présentent des tensions de seuil différentes, l'établissement dudit bit mémoire étant fonction du décalage entre lesdites tensions de seuil desdits couples.

Selon un second mode de réalisation, le dispositif selon l'invention comprend :
- des cinquième et sixième transistors, connectés respectivement entre les premier et deuxième transistors et respectivement entre les première et deuxième bornes et dont les grilles sont connectées à l'entrée d'initialisation dudit dispositif ;
- des septième et huitième transistors connectés respectivement entre les première et deuxième bornes et la source d'alimentation et dont les grilles sont connectées à ladite entrée d'initialisation dudit dispositif.

Selon une variante de ce second mode de réalisation, les cinquième et sixième transistors sont connectés, de façon alternative, respectivement entre les premier et deuxième transistors et la masse, leur grille étant connectée à l'entrée d'initialisation dudit dispositif.

Avantageusement, selon ce second mode de réalisation, les couples de premier et cinquième transistors et de deuxième et sixième transistors présentent des tensions de seuil différentes, l'établissement dudit bit mémoire étant fonction du décalage entre lesdites tensions de seuil desdits couples.

De préférence, les cinquième et sixième transistors sont de type nMos et les septième et huitième transistors sont de type pMos.

D'autres caractéristiques et avantages de la présente invention apparaîtront plus clairement à la lecture de la description suivante donnée à titre d'exemple illustratif et non limitatif et faite en référence aux figures annexées dans lesquelles :
- la figure 1, déjà décrite, illustre une cellule mémoire de l'état de la technique, basée sur l'association de deux d'inverseurs CMOS selon un couplage transversal avec des tensions de seuil respectives différentes, formant un circuit bistable utilisable dans un dispositif de mémorisation selon l'invention ;
- la figure 2 est une représentation d'un premier mode de réalisation de dispositif de mémorisation selon l'invention ;
- la figure 3 décrit en détail la structure du dispositif de mémorisation selon le premier mode de réalisation ;
- la figure 4 présente une variante de la structure illustrée à la figure 3 ;
- la figure 5 est une représentation d'un second mode de réalisation de dispositif de mémorisation selon l'invention ;
- la figure 6 décrit en détail la structure du dispositif de mémorisation selon le second mode de réalisation;
- la figure 7 présente une variante de la structure illustrée à la figure 6 ;
- la figure 8 illustre un chronogramme décrivant le fonctionnement de la cellule mémoire selon le premier mode de réalisation.

L'invention propose un dispositif de mémorisation d'un bit mémoire, muni d'un circuit bistable présentant des bornes de lecture/écriture complémentaires. Ce dispositif de mémorisation présente ainsi une structure similaire à celle qui a déjà été décrite en référence à la figure 1, à ceci près qu'une entrée spécifique est prévue pour être connectée au dispositif de mémorisation, permettant avantageusement d'initialiser le dispositif de mémorisation indépendamment de la montée d'alimentation.

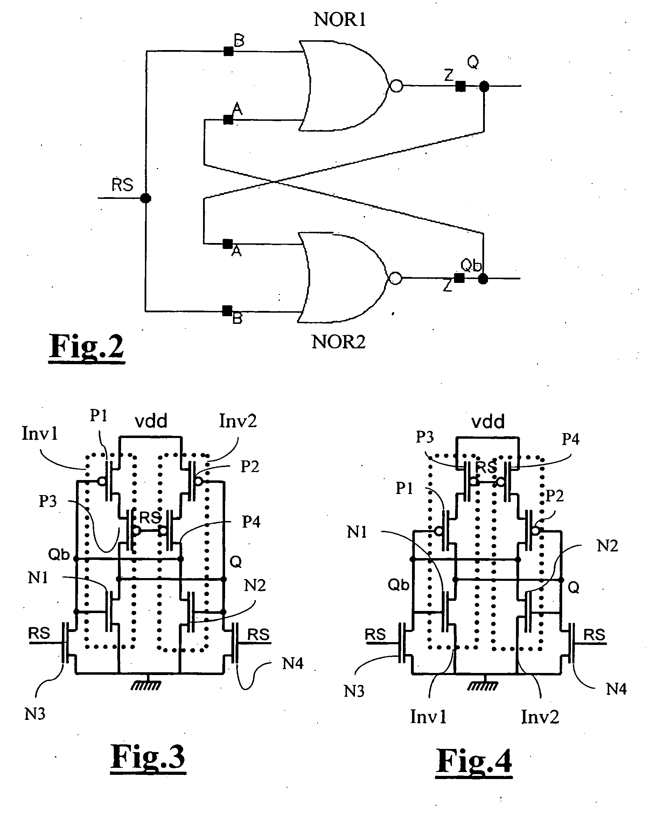

Des exemples de tels dispositifs de mémorisation sont illustrés aux figures 2 et suivantes.

La figure 2 illustre un premier mode de réalisation de l'invention. Le dispositif de mémorisation comprend donc un bistable 1 à deux bornes complémentaires Q et Qb. Cette figure illustre le schéma de réalisation du dispositif de mémorisation en deux portes NON-OU standards, respectivement NOR1 et NOR2. Les sorties Q et Qb de chacune des portes NOR1 et NOR2 sont rebouclées respectivement sur la première entrée de la porte NOR2 et de la porte NOR1.

Une entrée RS spécifique est alors prévue pour initialiser le dispositif et est appliquée à la deuxième entrée de chacune des portes NOR1 et NOR2. Un tel circuit présente alors deux états stables et son fonctionnement va plus particulièrement être décrit en référence à la figure 3, illustrant la réalisation des fonctions logiques de la figure 2 en technologie CMOS.

Le bistable 1 peut notamment présenter la structure illustrée à la figure 1. Aussi, les éléments de la figure 3 en commun avec ceux de la figure 1 gardent les mêmes références.

Le dispositif de mémorisation selon ce premier mode de réalisation comprend alors en sus des éléments déjà décrits, des transistors nMos N3 et N4, qui sont connectés entre la masse et respectivement les bornes Qb et Q du bistable. Les grilles de ces transistors N3 et N4 sont connectées à l'entrée RS.

Des transistors pMos P3 et P4 sont également prévus. Ils sont connectés respectivement entre les bornes Q et Qb et respectivement, les transistors pMos P1 et P2 de chaque inverseur Inv1 et Inv2. Les grilles des transistors P3 et P4 sont également connectées chacune à l'entrée RS d'initialisation.

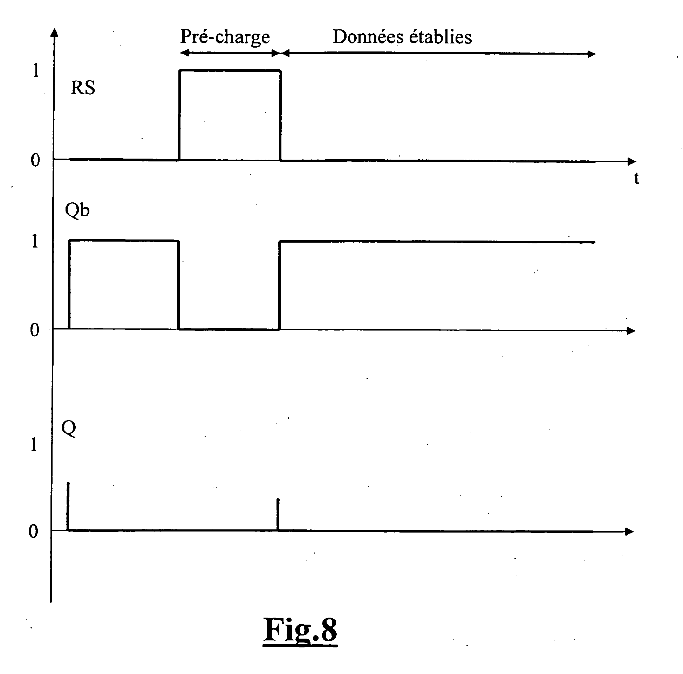

La figure 8 illustre les chronogrammes des signaux présents à l'entrée RS et sur les bornes Q et Qb du dispositif. L'entrée RS permet donc l'initialisation du dispositif. Ainsi, lorsque l'entrée de commande RS est mise sur l'état logique 1, les deux pMos P3 et P4 sont coupés, tandis que les deux nMos N3 et N4 conduisent. Les bornes Q et Qb se retrouvent alors à l'état logique 0.

Puis, dans un second temps, la polarité de l'entrée RS est modifiée, de sorte à la faire passer à l'état logique bas 0. Les deux pMos P3 et P4 deviennent alors passants tandis que les nMos N3 et N4 sont coupés. Les bornes Q et Qb ne sont donc plus dépendantes de la commande RS et vont évoluer selon l'état des quatre pMos P1, P2, P3 et P4 des inverseurs Inv1 et Inv2, de la même manière qu'expliqué précédemment en liaison avec la figure 1.

Ainsi, dans un exemple où la tension de seuil Vth1 choisie pour chacun des transistors du couple de transistors P1 et P3 de l'inverseur Inv1 est supérieure à la tension de seuil Vth2 choisie pour chacun des transistors du couple de transistors P2 et P4 de l'inverseur Inv2, l'état logique final 0 est atteint sur la borne Q et la borne Qb s'établit à l'état logique complémentaire 1, comme illustré à la figure 8 avec Vdd égale à 1 volt.

Au contraire, si la tension de seuil Vth1 du couple de transistors P1 et P3 de l'inverseur Inv1 est choisie inférieure à la tension de seuil Vth2 du couple de transistors P2 et P4 de l'inverseur Inv2, l'état logique final 1 est atteint sur la borne Q et la borne Qb s'établit à 0.

L'entrée RS, dans son premier état, permet donc d'initialiser les bornes Q et Qb, indépendamment de la montée de l'alimentation Vdd, en les pré-chargeant à 0 et, une fois que l'alimentation est fixée, l'entrée RS est placée dans un second état logique pour commander l'établissement des états logiques finaux au niveau des bornes Q et Qb en retrouvant la configuration classique des deux inverseurs de la figure 1 couplés avec des tensions de seuil différentes.

La figure 4 présente une variante de la structure illustrée à la figure 3, où les deux transistors pMos P3 et P4, commandés par l'entrée RS, sont disposés différemment. Dans cette variante, les deux transistors pMos P3 et P4 sont alors connectés respectivement entre les transistors pMos P1 et P2 et la source d'alimentation Vdd. Le fonctionnement reste identique à celui décrit en relation avec la structure de la figure 3.

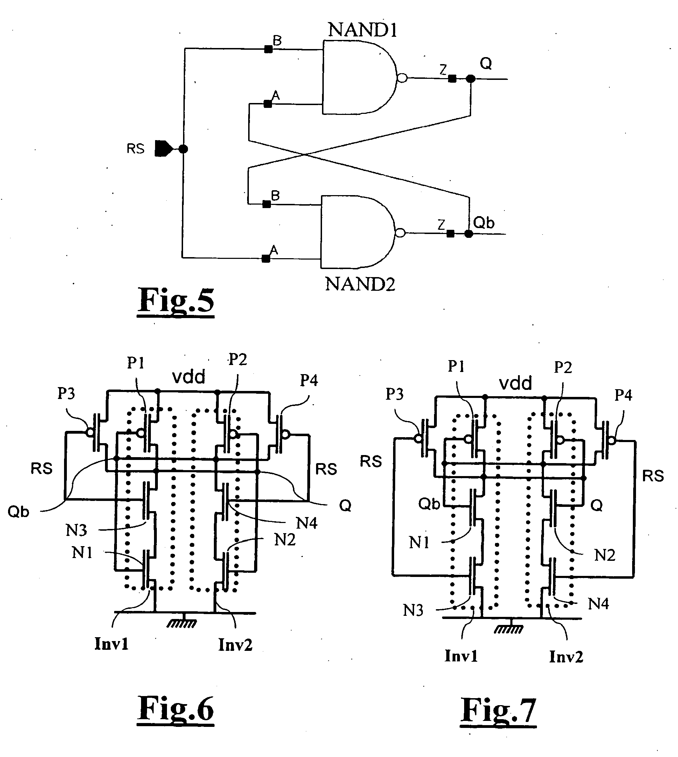

La figure 5 est une représentation d'un second mode de réalisation de dispositif de mémorisation selon l'invention. Cette figure illustre cette fois le schéma de réalisation du dispositif de mémorisation en deux portes NON-ET standards, respectivement NAND1 et NAND2. Les sorties Q et Qb de chacune des portes NAND1 et NAND2 sont rebouclées respectivement sur une première entrée de la porte NAND2 et de la porte NAND1.

L'entrée RS commune, prévue pour initialiser le dispositif, est alors appliquée à la deuxième entrée de chacune des portes NAND1 et NAND2. Le fonctionnement va maintenant être décrit en référence à la figure 6, illustrant la réalisation des fonctions logiques de la figure 5 en technologie CMOS.

En partant du bistable déjà décrit à la figure 1, les transistors nMos N3 et N4 sont, selon ce mode de réalisation, connectés respectivement entre les transistors nMos N1 de l'inverseur Inv1 et N2 de l'inverseur Inv2 et, respectivement, entre les bornes Q et Qb. Les grilles de ces transistors N3 et N4 sont connectées à l'entrée RS.

Les transistors pMos P3 et P4 sont quant à eux connectés respectivement entre les bornes Q et Qb et la source d'alimentation Vdd. Les grilles des transistors P3 et P4 sont également connectées chacune à l'entrée RS d'initialisation.

Dans cette configuration, au lieu de pré-charger les bornes Q et Qb à l'état logique 0 comme dans le mode de réalisation précédent, on vient les pré-charger à Vdd.

Pour ce faire, l'entrée RS est placée à l'état logique 0 pour la phase de pré-charge. Les deux nMos N3 et N4 sont donc coupés, tandis que deux pMos P3 et P4 conduisent, plaçant les bornes Q et Qb à l'état logique 1.

Puis, dans un second temps, la polarité de l'entrée RS est modifiée, de sorte à la placer à l'état logique 1. Les deux pMos P3 et P4 sont alors coupés, tandis que les nMos N3 et N4 deviennent passants. Les bornes Q et Qb ne sont donc plus dépendantes de la commande RS et vont évoluer classiquement selon l'état des quatre nMos N1, N2, N3 et N4 des inverseurs Inv1 et Inv2. En effet, pour le montage à porte NAND, on agit sur les tensions de seuil des nMOS.

Ainsi, dans un exemple où la tension de seuil Vth1 choisie pour chacun des transistors du couple de transistors N1 et N3 de l'inverseur Inv1 est prise supérieure à la tension de seuil Vth2 choisie pour chacun des transistors du couple de transistors N2 et N4 de l'inverseur Inv2, l'état logique final 1 est atteint sur la borne Q et la borne Qb s'établit à l'état logique complémentaire 0.

Au contraire, si la tension de seuil Vth1 des transistors N1 et N3 de l'inverseur Inv1 est choisie inférieure à la tension de seuil Vth2 des transistors N2 et N4 de l'inverseur Inv2, l'état logique final 0 est atteint sur la borne Q et la borne Qb s'établit à l'état complémentaire 1.

La figure 7 présente une variante de la structure illustrée à la figure 6, où les deux transistors nMos N3 et N4, commandés par l'entrée RS, sont disposés différemment. Dans cette variante, les deux transistors nMos N3 et N4 sont alors connectés respectivement entre les transistors N1 et N2 et la masse. Le fonctionnement reste identique à celui décrit en relation avec la structure de la figure 6.

Grâce à l'entrée RS, la phase de pré-charge des bornes Q et Qb est réalisée indépendamment de la montée de l'alimentation Vdd, garantissant que l'initialisation de la cellule mémoire ne sera pas perturbée par les conditions d'établissement de l'alimentation et notamment par sa vitesse de montée.

Par ailleurs, du fait que seules des cellules standards sont utilisées, telles que des portes logiques NON-OU ou des portes logiques NON-ET, le dispositif de mémorisation selon l'invention est difficile à identifier quand il est intégré au sein d'un circuit, ce qui est particulièrement avantageux dans le cadre d'applications de sécurité.

Une cellule peut être programmée au niveau du dessin de masque (layout). Plus précisément, les pMOS (ou nMOS) des inverseurs sont dessinés pour être de type différent (avec une tension de seuil standard d'un côté et une tension de seuil élevée de l'autre).

La programmation peut également être effectuée au niveau du procédé de fabrication, en modifiant la tension de seuil du transistor pMOS (ou nMOS) d'un des inverseurs, par exemple avec un équipement permettant de réaliser une implantation de type ebeam.

## Revendications

1. Dispositif de mémorisation d'un bit mémoire comprenant un circuit bistable (1) alimenté par une tension d'alimentation (Vdd) et présentant des première et deuxième bornes de lecture/écriture complémentaires (Q et Qb), **caractérisé en ce qu'**il comprend une entrée (RS) d'initialisation connectée audit circuit bistable, ladite entrée (RS) étant adaptée pour prendre un premier état commandant une phase de pré-charge dudit circuit bistable indépendante d'une phase de montée de l'alimentation et, suite à ladite phase de pré-charge, pour prendre un second état commandant l'établissement dudit bit mémoire et de son complément au niveau des dites bornes de lecture/écriture (Q et Qb).

2. Dispositif selon la revendication 1, **caractérisé en ce que** le circuit bistable (1) comprend :
- des premier et deuxième transistors (N1, N2) connectés entre la masse et respectivement lés première et deuxième bornes (Q et Qb), et dont les grilles sont connectées respectivement aux deuxième et première bornes (Qb et Q) ;
- des troisième et quatrième transistors (P1, P2) connectés respectivement entre les première et deuxième bornes (Q et Qb) et la source d'alimentation (Vdd), et dont les grilles sont connectées respectivement aux deuxième et première bornes (Qb et Q).

3. Dispositif selon la revendication 2, **caractérisé en ce que** les premier et deuxième transistors sont de type nMos, et **en ce que** les troisième et quatrième transistors sont de type pMos.

4. Dispositif selon les revendications 2 ou 3, **caractérisé en ce qu'**il comprend :
- des cinquième et sixième transistors (N3, N4), connectés entre la masse et respectivement les deuxième et première bornes (Qb et Q) et dont les grilles sont connectées à l'entrée (RS) d'initialisation dudit dispositif ;
- des septième et huitième transistors (P3, P4), connectés respectivement entre les première et deuxième bornes (Q et Qb) et respectivement les troisième et quatrième transistors (P1, P2) et dont les grilles sont connectées à ladite entrée (RS) d'initialisation dudit dispositif.

5. Dispositif selon la revendication 4, **caractérisé en ce que** les septième et huitième transistors (P3, P4) sont connectés, de façon alternative, respectivement entre les troisième et quatrième transistors (P1, P2) et la source d'alimentation (Vdd), leur grille étant connectée à l'entrée (RS) d'initialisation dudit dispositif.

6. Dispositif selon les revendications 4 ou 5, **caractérisé en ce que** les couples de troisième et septième transistors (P1, P3) et de quatrième et huitième transistors (P2, P4) présentent des tensions de seuil différentes, l'établissement dudit bit mémoire étant fonction du décalage entre lesdites tensions de seuil desdits couples.

7. Dispositif selon les revendications 2 ou 3, **caractérisé en ce qu'**il comprend :
- des cinquième et sixième transistors (N3, N4), connectés respectivement entre les premier et deuxième transistors (N1, N2) et respectivement entre les première et deuxième bornes (Q et Qb) et dont les grilles sont connectées à l'entrée (RS) d'initialisation dudit dispositif ;
- des septième et huitième transistors (P3, P4), connectés respectivement entre les première et deuxième bornes (Q et Qb) et la source d'alimentation (Vdd) et dont les grilles sont connectées à ladite entrée (RS) d'initialisation dudit dispositif.

8. Dispositif selon la revendication 7, **caractérisé en ce que** les cinquième et sixième transistors (N3, N4) sont connectés, de façon alternative, respectivement entre les premier et deuxième transistors (N1, N2) et la masse, leur grille étant connectée à l'entrée (RS) d'initialisation dudit dispositif.

9. dispositif selon les revendications 7 ou 8, **caractérisé en ce que en ce que** les couples de premier et cinquième transistors (N1, N3) et de deuxième et sixième transistors (N2, N4) présentent des tensions de seuil différentes, l'établissement dudit bit mémoire étant fonction du décalage entre lesdites tensions de seuil desdits couples.

10. Dispositif selon l'une quelconque des revendications 4 à 9, **caractérisé en ce que** les cinquième et sixième transistors (N3, N4) sont de type nMos et **en ce que** les septième et huitième transistors (P3, P4) sont de type pMos.

## Claims

1. A storage device of a memory bit comprising a bistable circuit (1) fed by a supply voltage (odd) and having first and second complementary read/write terminals (Q and Qb), **characterized in that** it has an initialization input (RS) connected to said bistable circuit, said input (RS) being designed to assume a first state controlling a pre-load phase of said bistable circuit independent of a power increase phase and, following said pre-load phase, to assume a second state controlling the setting up of said memory bit and its complement at the level of said read/write terminals (Q and Qb).

2. A device according to Claim 1, **characterized in that** the bistable circuit (1) includes:
- first and second transistors (N1, N2) connected between the earth and the first and second terminals (Q and Qb) respectively, and their gates being connected to the second and first terminals (Qb and Q) respectively;
- third and fourth transistors (P1, P2) connected between the first and second terminals (Q and Qb) respectively and the power source (Vdd), and their gates being connected to the second and first terminals (Qb and Q) respectively.

3. A device according to Claim 2, **characterized in that** the first and second transistors are of the nMos type, and **in that** the third and fourth transistors are of the pMos type.

4. A device according to Claims 2 or 3, **characterized in that** it includes:
- fifth and sixth transistors (N3, N4), connected between the earth and the second and first terminals (Qb and Q) respectively, and their gates being connected to the initialization input (RS) of said device;
- seventh and eighth transistors (P3, P4), connected between the first and second terminals (Q and Qb) respectively and the third and fourth transistors (P1, P2) respectively, and their gates being connected to said initialization input (RS) of said device.

5. A device according to Claim 4, **characterized in that** the seventh and eighth transistors (P3, P4) are alternatively connected between the third and fourth transistors (P1, P2) respectively and the power source (Vdd), their gate being connected to the initialization input (RS) of said device.

6. A device according to Claims 4 or 5, **characterized in that** the pairs of third and seventh transistors (P1, P3) and of fourth and eighth transistors (P2, P4) have different threshold voltages, said memory bit being set up as a function of the difference between said threshold voltages of said pairs.

7. A device according to Claims 2 or 3, **characterized in that** it includes:
- fifth and sixth transistors (N3, N4), connected between the first and second transistors (N1, N2) respectively and between the first and second terminals (Q and Qb) respectively and their gates being connected to the initialization input (RS) of said device;
- seventh and eighth transistors (P3, P4), connected between the first and second terminals (Q and Qb) respectively and the power source (Vdd), and their gates being connected to said initialization input (RS) of said device.

8. A device according to Claim 7, **characterized in that** the fifth and sixth transistors (N3, N4) are alternatively connected between the first and second transistors (N1, N2) respectively and the earth, their gate being connected to the initialization input (RS) of said device.

9. A device according to Claims 7 or 8, **characterized in that** the pairs of first and fifth transistors (N1, N3) and of second and sixth transistors (N2, N4) have different threshold voltages, said memory bit being set up as a function of the difference between said threshold voltages of said pairs.

10. A device according to any one of Claims 4 to 9, **characterized in that** the fifth and sixth transistors (N3, N4) are of the nMos type and **in that** the seventh and eighth transistors (P3, P4) are of the pMos type.

## Patentansprüche

1. Vorrichtung zur Speicherung eines Speicherbits umfassend einen bistabilen Schaltkreis (1), der durch eine Versorgungsspannung (Vdd) versorgt wird und einen ersten und einen zweiten komplementären Lese-/Schreibkontakt (Q und Qb) aufweist, **dadurch gekennzeichnet, dass** sie einen Initialisierungseingang (RS) umfasst, der mit dem bistabilen Schaltkreis verbunden ist, wobei der Eingang (RS) dazu ausgelegt ist, einen ersten Zustand anzunehmen, der eine Vorladephase des bistabilen Schaltkreises bewirkt, die unabhängig einer Anstiegsphase der Versorgung ist, und nach der Vorladephase einen zweiten Zustand anzunehmen, der die Einstellung des Speicherbits und dessen Komplements auf der Ebene der Lese-/Schreibkontakte (Q und Qb) bewirkt.

2. Vorrichtung nach Anspruch 1, **dadurch gekennzeichnet, dass** der bistabile Schaltkreis (1) umfasst:
- einen ersten und einen zweiten Transistor (N1, N2), die zwischen Masse und jeweils dem ersten und zweiten Kontakt (Q und Qb) angeschlossen sind und deren Tore jeweils am zweiten und ersten Kontakt (Qb und Q) angeschlossen sind;
- einen dritten und einen vierten Transistor (P1, P2), die jeweils zwischen dem ersten und zweiten Kontakt (Q und Qb) und der Versorgungsspannung (Vdd) angeschlossen sind und deren Tore jeweils am zweiten und ersten Kontakt (Qb und Q) angeschlossen sind.

3. Vorrichtung nach Anspruch 2, **dadurch gekennzeichnet, dass** der erste und zweite Transistor vom Typ nMos sind und dass der dritte und vierte Transistor vom Typ pMos sind.

4. Vorrichtung nach einem der Ansprüche 2 oder 3, **dadurch gekennzeichnet, dass** sie umfasst:
- einen fünften und einen sechsten Transistor (N3, N4), die zwischen Masse und jeweils dem zweiten und ersten Kontakt (Qb und Q) angeschlossen sind und deren Tore am Initialisierungseingang (RS) der Vorrichtung angeschlossen sind;
- einen siebten und einen achten Transistor (P3, P4), die jeweils zwischen dem ersten und zweiten Kontakt (Q und Qb) und jeweils dem dritten und vierten Transistor (P1, P2) angeschlossen sind und deren Tore am Initialisierungseingang (RS) der Vorrichtung angeschlossen sind.

5. Vorrichtung nach Anspruch 4, **dadurch gekennzeichnet, dass** alternativ der siebte und der achte Transistor (P3, P4) jeweils zwischen dem dritten und vierten Transistor (P1, P2) und der Versorgungsspannung (Vdd) angeschlossen sind, wobei deren Tor am Initialisierungseingang (RS) der Vorrichtung angeschlossen ist.

6. Vorrichtung nach einem der Ansprüche 4 oder 5, **dadurch gekennzeichnet, dass** die aus dem dritten und siebten Transistor (P1, P3) und dem vierten und achten Transistor (P2, P4) gebildeten Paare unterschiedliche Schwellenspannungen aufweisen, wobei die Einstellung des Speicherbits von dem Versatz zwischen den Schwellenspannungen der Paare abhängt.

7. Vorrichtung nach einem der Ansprüche 2 oder 3, **dadurch gekennzeichnet, dass** sie umfasst:
- einen fünften und einen sechsten Transistor (N3, N4), die jeweils zwischen dem ersten und zweiten Transistor (N1, N2) und jeweils dem ersten und zweiten Kontakt (Q und Qb) angeschlossen sind und deren Tore am Initialisierungseingang (RS) der Vorrichtung angeschlossen sind;
- einen siebten und einen achten Transistor (P3, P4), die jeweils zwischen dem ersten und zweiten Kontakt (Q und Qb) und der Versorgungsspannung (Vdd) angeschlossen sind und deren Tore am Initialisierungseingang (RS) der Vorrichtung angeschlossen sind.

8. Vorrichtung nach Anspruch 7, **dadurch gekennzeichnet, dass** alternativ der fünfte und der sechste Transistor (N3, N4) jeweils zwischen dem ersten und zweiten Transistor (N1, N2) und Masse angeschlossen ist, wobei deren Tor am Initialisierungseingang (RS) der Vorrichtung angeschlossen ist

9. Vorrichtung nach einem der Ansprüche 7 oder 8, **dadurch gekennzeichnet, dass** die aus dem ersten und fünften Transistor (N1, N3) und dem zweiten und sechsten Transistor (N2, N4) gebildeten Paare unterschiedliche Schwellenspannungen aufweisen, wobei die Einstellung des Speicherbits von dem Versatz zwischen den Schwellenspannungen der Paare abhängt.

10. Vorrichtung nach einem der Ansprüche 4 bis 9, **dadurch gekennzeichnet, dass** der fünfte und sechste Transistor (N3, N4) vom Typ nMos sind und dass der siebte und achte Transistor (P3, P4) vom Typ pMos sind.
